# EUROPEAN PATENT APPLICATION

(11) **EP 4 773 149 A1**
(43) Date of publication of application: **08.07.2026**
(21) Application number: 24860291.4
(22) Date of filing: 21.08.2024
(51) Int. Cl.: G21D 3/00, G21C 7/08, G06F 30/20

(54) **METHOD FOR PRODUCING NUCLEAR DESIGN CORE MODEL ACCOUNTING FOR LOAD FOLLOWING**

(30) Priority: 28.08.2023 KR 20230112950
(71) Applicant: Korea Hydro & Nuclear Power Co., Ltd, Gyeongju-si, Gyeongsangbuk-do 38120 (KR); KEPCO NUCLEAR FUEL CO., LTD., Daejeon 34057 (KR)
(72) Inventor: JUN, Seung Hwan, Sejong 30123 (KR); YU, Keuk Jong, Daejeon 34101 (KR); LEE, Jae Min, Daejeon 34101 (KR); LEE, Sang Seob, Daejeon 34101 (KR); SHIN, Sun Ho, Sejong 30100 (KR)
(74) Representative: Habermann, Hruschka & Schnabel
(86) International application number: PCT/KR2024/012399
(87) International publication number: WO 2025/048370

(57) **Abstract**

The present invention relates to a method for producing a nuclear design core model accounting for load following, the method comprising the steps of: receiving load-following requirements for a corresponding cycle, wherein the load-following requirements include the amount of power reduction, the number of load-following operations, and at least one of the time or duration of operation at reduced power; determining the amount of insertion of a control rod on the basis of the load-following requirements; determining the duration of insertion of the control rod on the basis of the amount of insertion of the control rod and the maximum insertion limit thereof; determining the time of insertion of the control rod by simulating core combustion by reflecting the duration of insertion of the control rod in a nuclear design code at each of a plurality of time points of the corresponding cycle; and producing a nuclear design core model accounting for load following on the basis of the determined amount of insertion of the control rod, the determined duration of insertion of the control rod, and the determined time of insertion of the control rod.

## Description

### Technical Field

The disclosure relates to a method for producing a nuclear design core model accounting for load following.

### Background Art

In the current practice, a nuclear design core model used for generation of nuclear design data and generation of safety-analysis interface data is based on full-power operation with all control rods withdrawn.

For this reason, in order to apply load-following operation to a nuclear power plant, the nuclear design core model that reflects partial power/control rod insertion conditions is essentially required.

To produce the nuclear design core model for load-following operation and generate associated nuclear design data, burnup calculations should be performed after accounting for the entire load-following operation history over the whole cycle, which is a difficult task requiring a significant amount of time and effort. Therefore, it is necessary to produce a simple burnup model for load-following operation, which effectively reflects changes in the core power distribution caused by load-following operation while enabling the load-following operation history to be input as simply as possible.

### Disclosure

### Technical Problem

Accordingly, an aspect of the disclosure is to provide a method for producing a nuclear design core model accounting for load following.

### Technical Solution

According to an embodiment of the disclosure, a method for producing a nuclear design core model accounting for load following includes receiving load-following requirements for a corresponding cycle, wherein the load-following requirements comprise at least one of an amount of power reduction, a number of load-following operations, and a time or period of operation at reduced power; determining a control rod insertion amount based on the load-following requirements; determining a control rod insertion period based on the control rod insertion amount and a maximum insertion limit; determining a control rod insertion timing by simulating core burnup with the control rod insertion period reflected into a nuclear design code for a plurality of time points within a corresponding cycle; and producing a nuclear design core model accounting for load following based on the determined control rod insertion amount, control rod insertion period, and control rod insertion timing.

The determining the control rod insertion amount may include using a core analysis code for each burnup level to determine a control rod insertion position, at which power and an axial shape index are maintained within allowable limits during power reduction operations at a time of control rod insertion, and the control rod insertion amount may be determined as a sum of products between the control rod insertion position and burnup.

The control rod insertion period may be determined by dividing the control rod insertion amount by the maximum insertion limit.

The plurality of time points for determining the control rod insertion timing may include a beginning of cycle, a middle of cycle, and an end of cycle.

The determining the control rod insertion timing may include performing a sensitivity evaluation of accident analysis interface parameters, and determining a time point among the plurality of time points, at which the most conservative interface parameter is generated, as the control rod insertion timing.

The control rods may include regulating control rods and part-strength control rods, and the control rod insertion amount, control rod insertion period, and control rod insertion timing may be determined for each of the regulating control rod and the part-strength control rod.

### Advantageous Effects

According to the disclosure, a method for producing a nuclear design core model accounting for load following is provided.

### Description of Drawings

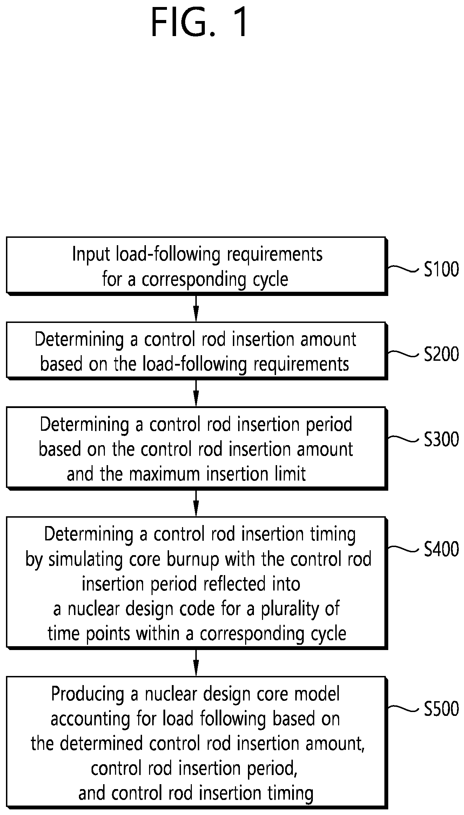

FIG. 1 is a flowchart of a method for producing a nuclear design core model accounting for load following according to an embodiment of the disclosure.

### Mode for Invention

Hereinafter, the disclosure will be described in more detail with reference to the accompanying drawings.

The accompanying drawings are provided merely as examples to describe the technical spirit of the disclosure in more detail, and therefore the spirit of the disclosure is not limited thereto. In addition, the accompanying drawings may be exaggerated in size, spacing, etc. to illustrate the relationships between the components.

Conventionally, nuclear design interface parameters have been generated based on a core analysis model at 100% power with all control rods withdrawn. Therefore, it is necessary to establish a core analysis model, in which control rods for regulating power during frequent power reduction operations (i.e., load-following operation) are inserted, and to generate the nuclear design interface parameters based on the established model.

The disclosure relates to a method for producing a core analysis model to generate nuclear design interface parameters by reflecting the impact of the control rods within the core when power reduction operation of a nuclear power plant is required by a power exchange, etc., unlike the conventional full (100%) power operation.

Below, a method for producing a nuclear design core model accounting for load following according to an embodiment of the disclosure will be described with reference to FIG. 1.

First, load-following requirements for a corresponding cycle are input (S100).

Here, the load-following requirements include at least one of an amount of power reduction, a number of load-following operations, and a time or period of operation at reduced power.

A core analysis model accounting for load following should be produced for each cycle (1 to 2 years). Therefore, prior to the start of each cycle, consultation (or decision) is preliminarily required between a power exchange (or power system operator) and a corresponding nuclear power plant with regard to the load-following requirements, such as a maximum required amount of power reduction (e.g., 30, 40, 50% power output), an expected number of power reduction operations (times per year), and a duration of operation at the reduced power (hours). According to the disclosure, the core analysis model for generating core interface parameters used as inputs for the safety analysis of a nuclear power plant is produced based on the derived load-following requirements.

Next, a control rod insertion amount is determined based on the load-following requirements (S200).

In determining the control rod insertion amount, a core analysis code is used for each burnup level to determine a control rod insertion position at which the power and the axial shape index (ASI) are maintained within allowable limits during power reduction operations at the time of control rod insertion. The control rod insertion amount may be determined as a sum of products between the control rod insertion position (i.e., a control rod insertion length) and the burnup as follows.

Control rod insertion amount = Σ (control rod insertion length * burnup)

The insertion amount may be determined as the control rod insertion position (amount) at which an optimal ASI is maintained after performing a load-following operation simulation calculation using the core analysis code to ensure that the power and the ASI are maintained within the allowable limits during the power reduction operation at the determined insertion time.

Subsequently, a control rod insertion period is determined based on the control rod insertion amount and the maximum insertion limit (S300).

The control rod insertion period refers to a predetermined period (e.g., one year) during which the control rods remain inserted in the core.

The control rod insertion period is determined by dividing the control rod insertion amount by the maximum insertion limit. The maximum insertion limit has already been determined according to core types, and may vary depending on the core types.

In other words, if the total control rod insertion amount of the regulating banks is 194,250 and operation is performed by inserting the control rods up to the maximum insertion limit of 28%, the control rod insertion period for the regulating banks is calculated as 7,700 MWD/MTU (194,250 / 28). The insertion period of part-strength control rods is also calculated in the same manner.

Next, a control rod insertion timing is determined by simulating core burnup with the control rod insertion period reflected into a nuclear design code for a plurality of time points within a corresponding cycle (S400).

The plurality of time points for determining the control rod insertion timing includes a beginning of cycle, a middle of cycle, and an end of cycle.

In determining the control rod insertion timing, a sensitivity evaluation of accident analysis interface parameters is performed, and a time point among the plurality of time points, at which the most conservative interface parameter is generated, may be determined as the control rod insertion timing. Here, "conservative interface parameters" refer to interface parameters (accident analysis input data) that deteriorate the results of accident analysis (safety analysis). Typically, the end of cycle is expected to generate the conservative interface parameters.

In the steps described above, the control rods include regulating control rods and part-strength control rods, and the insertion amount, insertion period, and insertion timing of the control rods may be determined for each of the regulating control rod and the part-strength control rod.

Finally, a nuclear design core model accounting for load following is produced based on the determined control rod insertion amount, control rod insertion period, and control rod insertion timing (S500).

Nuclear design is the process of generating interface parameters that serve as inputs for safety analysis/accident analysis, and the fundamental model required for nuclear design is the nuclear design core model. The "nuclear design core model" according to the disclosure refers to the basic core model necessary for nuclear design that accounts for load following.

The nuclear design core model produced according to the disclosure provides a simple approach for producing core models applicable to load-following operations with various operation histories, and a conservative approach capable of contributing to reducing core design costs and facilitating licensing.

The foregoing embodiments are provided merely as examples for describing the disclosure, and the disclosure is not limited thereto. A person having ordinary knowledge in the art to which the disclosure pertains can make various modifications from the foregoing embodiments and implement the disclosure. Therefore, the technical scope of the disclosure should be defined by the appended claims.

## Claims

1. A method for producing a nuclear design core model accounting for load following, the method comprising:
receiving load-following requirements for a corresponding cycle, wherein the load-following requirements comprise at least one of an amount of power reduction, a number of load-following operations, and a time or period of operation at reduced power;
determining a control rod insertion amount based on the load-following requirements;
determining a control rod insertion period based on the control rod insertion amount and a maximum insertion limit;
determining a control rod insertion timing by simulating core burnup with the control rod insertion period reflected into a nuclear design code for a plurality of time points within a corresponding cycle; and
producing a nuclear design core model accounting for load following based on the determined control rod insertion amount, control rod insertion period, and control rod insertion timing.

2. The method of claim 1, wherein
the determining the control rod insertion amount comprises using a core analysis code for each burnup level to determine a control rod insertion position, at which power and an axial shape index are maintained within allowable limits during power reduction operations at a time of control rod insertion, and
the control rod insertion amount is determined as a sum of products between the control rod insertion position and burnup.

3. The method of claim 2, wherein the control rod insertion period is determined by dividing the control rod insertion amount by the maximum insertion limit.

4. The method of claim 1, wherein the plurality of time points for determining the control rod insertion timing comprises a beginning of cycle, a middle of cycle, and an end of cycle.

5. The method of claim **4,** wherein the determining the control rod insertion timing comprises performing a sensitivity evaluation of accident analysis interface parameters, and determining a time point among the plurality of time points, at which the most conservative interface parameter is generated, as the control rod insertion timing.

6. The method of claim 1, wherein
the control rods comprises regulating control rods and part-strength control rods, and
the control rod insertion amount, control rod insertion period, and control rod insertion timing are determined for each of the regulating control rod and the part-strength control rod.
